# DEMANDE DE BREVET EUROPEEN

(11) **EP 1 294 095 A2**
(43) Date de publication de la demande: **19.03.2003**
(21) Numéro de dépôt: 02354140.2
(22) Date de dépôt: 11.09.2002
(51) Int. Cl.: H03K 17/94

(54) **Circuit d'interface logique limiteur de courant**

(30) Priorité: 12.09.2001 FR 0111784
(71) Demandeur: STMicroelectronics S.A., 92120 Montrouge (FR)
(72) Inventeur: Castagnet, Thierry, 37000 Tours (FR); Ladiray, Olivier, 37270 Montlouis sur Loire (FR)
(74) Mandataire: de Beaumont, Michel

(57) **Abrégé**

L'invention concerne un circuit d'interface entre un capteur logique et une barrière d'isolement d'entrée logique (3) d'un circuit de traitement, comprenant un élément (23) de protection contre les surtensions en entrée, un circuit limiteur de courant (24) connecté en série entre une borne d'entrée et une borne de sortie du circuit d'interface, et un étage de commande (25) connecté en parallèle avec l'élément d'isolement galvanique à commander pour en contrôler les états logiques, l'étage de commande inhibant le fonctionnement de l'élément d'isolement galvanique si le courant d'entrée est inférieur à un seuil prédéterminé (Iref).

## Description

La présente invention concerne un circuit d'interface entre un capteur logique et une barrière d'isolement d'une entrée logique d'un circuit de traitement. L'invention s'applique, de façon générale, à des circuits d'entrée/sortie de circuits logiques de traitement. Il s'agit, par exemple, de circuits d'entrée/sortie d'automates programmables ou similaires.

Les entrées logiques de circuits de traitement sont le plus souvent destinées à détecter un état logique transmis par un capteur, par exemple, un capteur deux points, un capteur trois points, un détecteur de proximité ou la sortie d'un relais. Ces informations sont collectées par un système alimenté par une tension continue. Un niveau logique bas est généralement représenté par le potentiel le plus négatif de l'alimentation (généralement 0 volt) et un niveau logique haut est le plus souvent représenté par le potentiel le plus positif (Vcc).

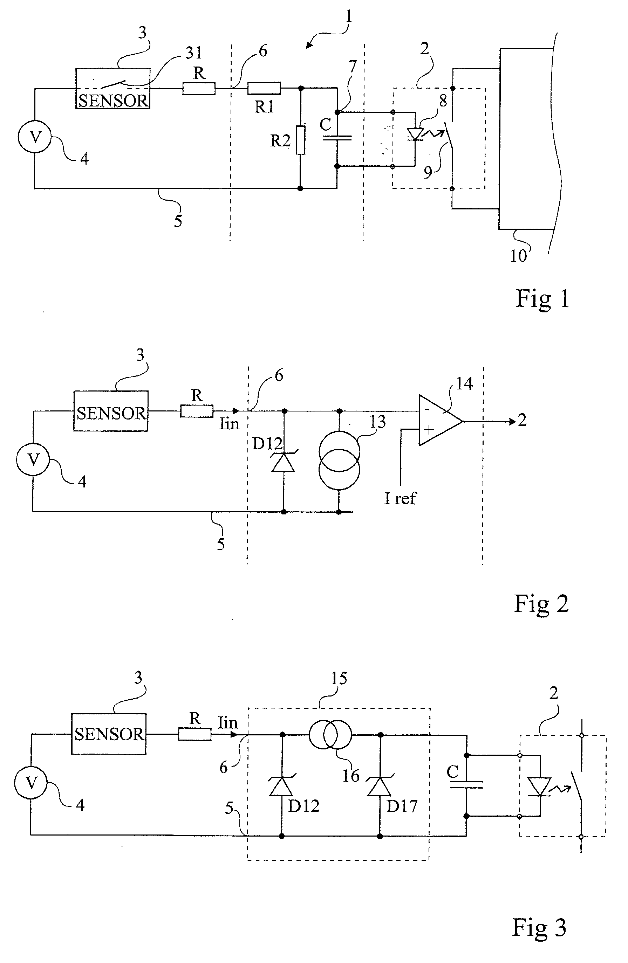

La figure 1 représente, de façon schématique et partielle, un premier exemple classique de circuit d'interface 1 du type auquel s'applique la présente invention. Un capteur 3 (SENSOR) le plus souvent constitué d'un interrupteur 31 est alimenté par une tension V, fournie, par exemple, par une batterie 4 ou une alimentation continue. Le potentiel de référence de la tension d'alimentation 4 est commun avec celui du circuit d'interface 1. Dans l'exemple de la figure 1, le circuit 1 est réalisé au moyen d'éléments discrets passifs, plus précisément un pont de résistances R, R1, R2 filtré en sortie par un condensateur C. En d'autres termes, une électrode du condensateur C et une borne de la résistance R2 sont connectées à la borne 5 de référence d'application de la tension V. Le capteur 3 est connecté en série avec le générateur 4 entre la borne 5 et une borne 6 d'entrée du circuit d'interface correspondant à une première borne de la résistance R1. L'autre borne de la résistance R1 est connectée à la deuxième borne de la résistance R2 et à la deuxième électrode du condensateur C définissant une borne 7 de sortie du circuit d'interface 1. Le plus souvent, une résistance R de protection est intercalée entre le capteur 3 et la borne 6. Le condensateur C est en parallèle avec un élément d'isolement galvanique, dans cet exemple, un optocoupleur 2. L'optocoupleur 2 est constitué d'une photodiode 8 commandant un interrupteur 9. Les deux bornes de la photodiode 8 sont connectées aux électrodes du condensateur C tandis que les deux bornes de l'interrupteur 9 sont reliées aux entrées de l'unité de traitement 10 représentée partiellement et non détaillée. Dans le circuit de la figure 1, la commande de l'optocoupleur 2 est proportionnelle au courant d'entrée du circuit d'interface, c'est-à-dire au courant dans la résistance R. Quand l'interrupteur 31 du capteur 3 est ouvert, la photodiode n'est pas alimentée et l'interrupteur 9 est ouvert. Quand l'interrupteur 31 est fermé, un courant circule dans les résistances R, R1 et R2. La tension filtrée aux bornes du condensateur C polarise la photodiode 8 qui ferme donc l'interrupteur 9.

La figure 2 représente un deuxième exemple classique de circuit d'interface 11 réalisé sous forme intégrée. Comme en figure 1, le capteur 3 est en série avec une source 4 de tension d'alimentation et une résistance de protection R. Le circuit d'interface 11, représenté partiellement, comporte une diode zener D12 connectée entre la borne d'entrée positive 6 du circuit 11 et la borne de référence 5. Une source de courant 13 est connectée en parallèle avec la diode D12 dont l'anode est côté borne 5. La borne 6 est reliée à l'entrée inverseuse d'un amplificateur 14 dont l'entrée non-inverseuse reçoit un courant de référence Iref. La sortie de l'amplificateur 14 constitue la borne de sortie du circuit d'interface 11 à destination de la barrière d'isolement 2, par exemple, un optocoupleur (non représenté). Le rôle de la source de courant 13 est de fournir une adaptation d'impédance en entrée de l'amplificateur 14 tandis que la diode D12 sert à limiter cette tension d'entrée. Selon que l'interrupteur que comporte le capteur 3 est passant ou bloqué, l'amplificateur 14 monté en comparateur fournit en sortie un potentiel nul ou un potentiel correspondant à sa propre tension d'alimentation (c'est-à-dire la tension V).

La figure 3 représente un troisième exemple classique de circuit d'interface 15. Dans cet exemple, une diode zener D12 est connectée aux bornes 6 et 5 d'entrée du circuit d'interface qui, comme précédemment, sont reliées par la résistance de protection R, le capteur 3 et la source de tension 4 en série. Une capacité C de filtrage est disposée en parallèle avec l'optocoupleur 2. La borne la plus positive correspondant à une première électrode de la capacité C est reliée à l'anode de la diode zener D12 par une source de courant 16. Le cas échéant, une deuxième diode zener D17 est connectée en parallèle avec le condensateur C. Comme dans le circuit de la figure 2, le limiteur de courant ne sert qu'à adapter l'impédance d'entrée du circuit.

Bien que le plus souvent l'élément d'isolation galvanique soit constitué par un optocoupleur, on peut rencontrer d'autres circuits par exemple à transformateur ou à condensateur. Dans ce cas, le circuit d'adaptation est associé à un oscillateur.

Le plus souvent, plusieurs circuits d'interface sont associés sur une même carte d'entrée/sortie. Une telle carte d'entrée/sortie logique regroupe par exemple, 4, 8, 16 ou 32 entrées.

Un inconvénient commun aux solutions classiques est le recours nécessaire à une résistance R de protection entre le capteur et le circuit d'interface. Cette résistance engendre une dissipation qui est à multiplier par le nombre d'entrées logiques.

Les circuits des figures 2 et 3 constituent des circuits dits "rail to rail" dans lesquels les deux bornes d'alimentation sont reliées par des diodes. Un problème qui se pose dans de tels circuits est qu'en présence de surcharge, celle-ci est envoyée sur la tension d'alimentation que l'on veut au contraire généralement stabiliser.

Une contrainte supplémentaire de circuits à limiteur de courant auxquels s'applique plus particulièrement l'invention est qu'en dessous d'un certain courant circulant dans le capteur, l'état logique fourni en sortie doit rester à zéro. En d'autres termes, l'optocoupleur doit rester éteint pour un courant Iin inférieur à un certain seuil. En pratique, des normes fixent ce seuil à quelques milliampères (par exemple 1,5 milliampère).

Un objet de la présente invention est de proposer un circuit d'interface qui permette de respecter un seuil d'activation en courant.

Un autre objet de l'invention est de minimiser le nombre de composants sur une carte d'entrée/sortie pourvue de circuits d'interface logiques.

L'invention vise également à minimiser les pertes dans chaque circuit d'interface d'entrée.

L'invention vise plus généralement à améliorer la qualité et l'immunité au bruit du transfert de l'information logique depuis un capteur jusqu'à une unité de traitement ou analogue. En particulier, le circuit d'interface doit résister aux perturbations électromagnétiques.

Dans une application particulière de la présente invention où la photodiode de l'optocoupleur est en série avec l'élément limiteur de courant, l'obtention d'un seuil d'activation inférieur à la tension d'alimentation du circuit d'interface constitue une difficulté supplémentaire. En effet, la tension aux bornes de la photodiode (et éventuellement la tension supplémentaire d'une diode électroluminescente) s'ajoute à la tension aux bornes de l'élément limiteur de courant.

Pour atteindre ces objets et d'autres, la présente invention prévoit un circuit d'interface entre un capteur logique et une barrière d'isolement d'entrée logique d'un circuit de traitement, comprenant :
un élément de protection contre les surtensions en entrée ;
un circuit limiteur de courant connecté en série entre une borne d'entrée et une borne de sortie du circuit d'interface ; et
un étage de commande connecté en parallèle avec l'élément d'isolement galvanique à commander pour en contrôler les états logiques, l'étage de commande inhibant le fonctionnement de l'élément d'isolement galvanique si le courant d'entrée est inférieur à un seuil prédéterminé.

Selon un mode de réalisation de la présente invention, le circuit de limitation de courant est constitué d'un premier élément dérivant une portion du courant d'entrée vers un potentiel de référence et d'un deuxième élément connecté en série entre les bornes d'entrée et de sortie du circuit d'interface.

Selon un mode de réalisation de la présente invention, l'étage de commande est constitué d'un comparateur dont une première entrée reçoit une référence de courant prédéterminée à comparer avec une image du courant en entrée du circuit.

Selon un mode de réalisation de la présente invention, le premier élément limiteur de courant est constitué de trois transistors montés en miroir, un premier transistor étant associé à un circuit de référence de tension tandis qu'un deuxième transistor est associé à une résistance de référence, un troisième transistor reliant les bornes d'entrée et de sortie du circuit.

Selon un mode de réalisation de la présente invention, un quatrième transistor monté en suiveur est intercalé entre le deuxième transistor et la résistance de référence.

Selon un mode de réalisation de la présente invention, une résistance de démarrage est connectée en parallèle sur le premier transistor.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 à 3 qui ont été décrites précédemment sont destinées à exposer l'état de la technique et le problème posé ;
la figure 4 représente, de façon très schématique, un mode de réalisation d'un circuit d'interface selon la présente invention ; et
la figure 5 représente un schéma électrique plus détaillé d'un mode de réalisation d'un circuit d'interface selon l'invention.

Les mêmes éléments ont été désignés par les mêmes références aux différentes figures. Pour des raisons de clarté, seuls les constituants du circuit d'interface qui sont utiles à la compréhension de l'invention ont été représentés aux figures et seront décrits par la suite.

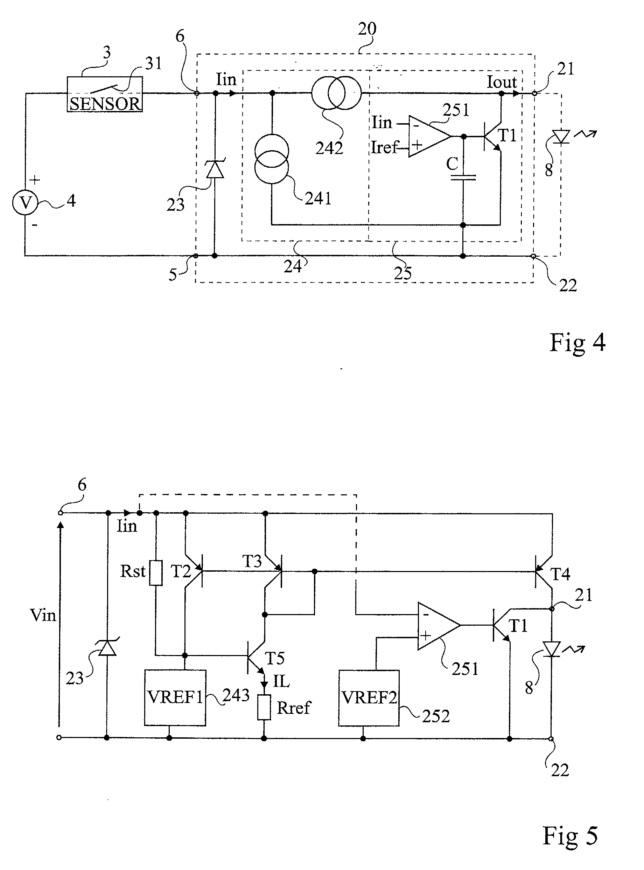

La figure 4 représente, de façon très schématique, un mode de réalisation d'un circuit d'interface selon l'invention. Comme précédemment, ce circuit intégré d'interface 20 est destiné à recevoir sur une entrée 6 un courant Iin provenant d'un capteur 3 formé d'un interrupteur logique 31. Le capteur est alimenté par une source de tension 4 et est connecté en série avec cette source 4 entre la borne 6 et une borne 5 constituant un potentiel de référence (généralement la masse).

Le circuit 20 comporte une borne de sortie 21 destinée à être connectée à une barrière d'isolement, de préférence une photodiode 8 d'un optocoupleur représenté partiellement, l'anode de la photodiode étant connectée à la borne 21 tandis que sa cathode est connectée au potentiel de référence (par exemple à une borne 22 du circuit 20 intégré relié à la borne 5).

Le circuit 20 comprend essentiellement :
un élément de protection 23 contre les surtensions. Cet élément est, par exemple, constitué d'une diode zener connectée entre les bornes d'entrée 6 et 5, la cathode de la diode zener étant connectée à la borne 6 ;
un circuit 24 limiteur de courant disposé en série avec le capteur et destiné à adapter l'impédance d'entrée du circuit ; et
un étage de commande 25 de l'optocoupleur connecté en parallèle avec l'élément d'isolement galvanique et qui en contrôle les états logiques.

Une caractéristique de la présente invention est que le circuit limiteur de courant série 24 n'est pas de type résistif. Comme on peut le remarquer sur la figure 4, aucune résistance limitrice n'est prévue entre le capteur 3 et le circuit d'interface. En d'autres termes, les pertes engendrées par l'élément limiteur sont proportionnelles à la tension et non au carré de cette tension comme dans le cas d'un élément résistif.

Selon le mode de réalisation préféré de l'invention illustré par la figure 4, le circuit limiteur de courant 24 est constitué d'un premier élément 241 limiteur connecté entre la borne 6 et la masse, et qui est donc destiné à dériver une partie du courant vers la masse et d'un deuxième élément limiteur 242 connecté entre les bornes 6 et 21, c'est-à-dire en série avec le capteur et l'optocoupleur. Le rapport entre les courants circulant dans les éléments 241 et 242 est fonction de l'application. Par exemple, l'élément limiteur série dérive 75 % du courant Iin tandis que l'élément limiteur parallèle en dérive 25 %. Le courant de sortie Iout à destination de l'optocoupleur est alors inférieur au courant d'entrée Iin.

Une telle configuration permet de rendre le seuil d'activation du circuit d'interface moins sensible à la tension du circuit de sortie (l'optocoupleur).

L'étage de commande 25 est essentiellement constitué d'un comparateur 251 dont une première entrée (non-inverseuse) reçoit une tension image d'un courant de référence Iref et dont une deuxième entrée (inverseuse) reçoit une tension image du courant d'entrée Iin. La sortie du comparateur 251 commande un interrupteur T1 (dans cet exemple un transistor bipolaire de type NPN) qui est connecté en parallèle avec le circuit d'isolement galvanique (plus précisément la photodiode 8). La sortie du comparateur 251 est par ailleurs connectée à la masse au moyen d'un condensateur C pour retarder ses transitions et améliorer l'immunité du circuit lorsqu'il est soumis à des transitions rapides.

La figure 5 représente un schéma plus détaillé du circuit d'interface de la figure 4. Le circuit limiteur de courant 24 est constitué principalement de trois transistors bipolaires T2, T3 et T4 (PNP) montés en miroirs, d'un circuit de référence de tension 243 (VREF1), et d'un transistor bipolaire T5 (NPN), monté en suiveur de tension. Les transistors T2, T3 et T4 ont leurs émetteurs respectifs connectés à la borne 6 et leurs bases connectées ensemble. Le collecteur du transistor T2 est relié à la borne 22 par le circuit de référence de tension 243. Le transistor T3 a sa base connectée à son collecteur. Le collecteur du transistor T3 est relié à la borne 22 par le transistor T5 en série avec une résistance Rref, le collecteur du transistor T5 étant relié au collecteur du transistor T3. La base du transistor T5 est reliée au collecteur du transistor T2 et, par une résistance de démarrage Rst, à la borne 6. Le collecteur du transistor T4 est relié à la borne de sortie 21.

Le circuit limiteur de courant est réglé par le courant circulant dans la résistance Rref. Ce courant IL est égal VL/Rref, où VL représente la tension aux bornes de la résistance Rref, ou encore VREF1-VBE/Rref, où VBE représente la tension base-émetteur du transistor T5. Le courant IL passe dans le transistor T3 et est recopié dans le transistor T4 qui a pour fonction d'alimenter en courant l'optocoupleur.

Le circuit 243 est, de préférence, un circuit de type "bandgap" calibré de telle manière qu'il compense le coefficient de température de la résistance Rref. Si le coefficient de température est positif, la tension aux bornes de la résistance Rref sera plus élevée en haute température qu'en basse température. Le principe de fonctionnement du circuit "bandgap" est basé sur la mise en série d'une diode (dont le coefficient de température est négatif) avec une résistance dont le courant a un coefficient de température positif. Selon la valeur de cette résistance, la tension de référence résultante peut être stable en température, augmenter ou diminuer avec la température.

La réalisation d'un circuit de référence de tension de type "bandgap" est connue et n'a pas besoin d'être détaillée davantage. Une telle réalisation et le choix du comportement en température en fonction de l'application sont à la portée de l'homme du métier.

La résistance Rst sert au démarrage du circuit en fournissant un courant au circuit 243 aux bornes duquel la tension croît jusqu'à ce que le circuit démarre. Le transistor T2 a ensuite pour rôle d'alimenter le circuit 243 en parallèle de la résistance Rst. Le courant dans le transistor T2 est proportionnel à celui passant dans le transistor T3. La valeur de la résistance Rst est suffisamment élevée (par exemple, plusieurs centaines de kilo-ohms) pour ne pas influencer le rapport entre le courant Iin et la tension Vin.

En figure 5, on retrouve également le circuit de commande 25 constitué du comparateur 251. En pratique, une tension de référence VREF2 image d'un courant de référence Iref est générée par un circuit 252 pour être fournie à l'entrée non-inverseuse du comparateur 251. Par exemple, le circuit 252 est basé sur un deuxième circuit de référence de tension compensée en température de type "bandgap". Le condensateur C de filtrage n'a pas été représenté. Il sera toutefois généralement présent. L'entrée négative du comparateur 251 prélève une image du courant d'entrée par tout moyen adapté.

La référence de courant Iref du comparateur 251 correspond au courant seuil en deçà duquel le signal logique ne doit pas basculer. En reprenant l'exemple précédent, le courant Iref est de l'ordre de quelques milliampères (par exemple 1,5 milliampères). Si le courant Iin est inférieur à la référence, le courant de sortie est nul. S'il est supérieur à la référence, le courant de sortie est égal à une portion du courant d'entrée (par exemple 75 % en raison de la dérivation effectuée par la source de courant 241 en parallèle).

De façon optionnelle, on pourra prévoir en parallèle à la diode 8 de l'optocoupleur, une deuxième diode zener (non représentée) de protection contre les surtensions du type de la diode D17 de la figure 3.

Bien entendu, la présente invention est susceptible de diverses variantes et modifications qui apparaîtront à l'homme de l'art. En particulier, la réalisation pratique des circuits de référence de tension compensés en température sera choisie en fonction de l'application. De plus, le nombre de circuits d'interface associés sur une carte d'entrée/sortie dépend de l'application. On notera simplement que l'invention présente l'avantage de minimiser la dissipation au sein de la carte en réduisant individuellement les pertes au sein de chaque circuit d'interface. De plus, l'élément de protection contre les surtensions 23 est intégré avec le circuit d'interface propre à chaque entrée logique. Par conséquent, dans une carte d'entrée/sortie pourvue de plusieurs circuits, chaque entrée possède sa propre protection contre les surtensions. Cela élimine tout chemin parasite sur les lignes d'alimentation comme ce serait le cas avec une protection centralisée contre les surtensions.

## Revendications

1. Circuit d'interface entre un capteur logique (3) et une barrière d'isolement (2) d'entrée logique d'un circuit de traitement (10), **caractérisé en ce qu'**il comprend :
un élément (23) de protection contre les surtensions en entrée ;
un circuit limiteur de courant (24) connecté en série entre une borne d'entrée (6) et une borne de sortie (21) du circuit d'interface ; et
un étage de commande (25) connecté en parallèle avec l'élément d'isolement galvanique à commander pour en contrôler les états logiques, l'étage de commande inhibant le fonctionnement de l'élément d'isolement galvanique si le courant d'entrée est inférieur à un seuil prédéterminé (Iref).

2. Circuit selon la revendication 1, **caractérisé en ce que** le circuit de limitation de courant (24) est constitué d'un premier élément (241) dérivant une portion du courant d'entrée vers un potentiel de référence et d'un deuxième élément (242) connecté en série entre les bornes d'entrée et de sortie du circuit d'interface.

3. Circuit selon la revendication 1 ou 2, **caractérisé en ce que** l'étage de commande (25) est constitué d'un comparateur (251) dont une première entrée reçoit une référence de courant prédéterminée à comparer avec une image du courant en entrée du circuit.

4. Circuit selon la revendication 2, **caractérisé en ce que** le premier élément limiteur de courant (241) est constitué de trois transistors (T2, T3, T4) montés en miroir, un premier transistor (T2) étant associé à un circuit (243) de référence de tension (VREF1) tandis qu'un deuxième transistor (T3) est associé à une résistance de référence (Rref), un troisième transistor (T4) reliant les bornes d'entrée (6) et de sortie (21) du circuit.

5. Circuit selon la revendication 4, **caractérisé en ce qu'**un quatrième transistor (T5), monté en suiveur, est intercalé entre le deuxième transistor (T3) et la résistance de référence (Rref).

6. Circuit selon la revendication 4, **caractérisé en ce qu'**une résistance de démarrage (Rst) est connectée en parallèle sur le premier transistor (T2).
